# EUROPEAN PATENT SPECIFICATION

(11) **EP 0 717 319 B1**
(45) Date of publication and mention of the grant of the patent: **11.04.2001**
(21) Application number: 95308435.7
(22) Date of filing: 24.11.1995
(51) Int. Cl.: G03F 7/004

(54) **Photoacid generating composition used in radiation-sensitive compositions**
Durch Belichtung einer Säure erzeugende Zusammensetzung für strahlungsempfindliche Zusammensetzungen
Composition génératrice d'acide par exposition à la lumière, utilisée dans des compositions sensibles aux radiations

(30) Priority: 06.12.1994 US 350303
(43) Date of publication of application: 19.06.1996
(73) Proprietor: OCG MICROELECTRONIC MATERIALS, INC., Cheshire, Connecticut 06410-0586 (US)
(72) Inventor: Slater, Sydney G., Providence, Rhode Island 02907 (US)
(74) Representative: Bannerman, David Gardner

(56) References cited:
- US-A- 5 135 838

## Description

The present invention relates to a specific class of photoacid generating composition (PAG). Also, the present invention relates to chemically amplified-type radiation-sensitive compositions, especially for use at deep UV wavelengths, containing this specific class of photoacid generating composition.

Photoresists are photosensitive films used to transfer images to a substrate. They form negative or positive images. After a coating of a photoresist is formed onto a substrate, the coating is selectively exposed through a photomask to a source of activating energy such as ultraviolet light. The photomask has areas that are opaque to activating radiation and other areas that are transparent to activating radiation. The pattern in the photomask of opaque and transparent areas defines a desired image to be transferred to a substrate. A relief image is provided upon development of the latent image patterned in the resist coating. The use of photoresists are generally described, for example, in Deforest, Photoresist Materials and Processes, McGraw Hill Book Co., New York (1975); and in Moreau, Semiconductor Lithography, Principles, Practices, and Materials, Plenum Press, New York (1988).

Known photoresists can form features having resolution and size sufficient for many commercial applications. However, for many other applications, the need exists for new photoresists that can provide highly resolved images of submicron dimensions.

Deep UV photolithography is destined to be used for patterning dimensions of 0.35 µm or less. Currently, two types of exposure tools are available, lithographic processing of semiconductor substrates at Deep UV wave lengths, namely:
(a) KrF Excimer Laser Steppers and
(b) Mercury lamp based Micrascan exposure tools.

The excimer based steppers are compatible with resists having moderate exposure dose requirements, as these exposure tools provide considerable power at the wafer plane. Mercury based tools on the other hand, having considerably less power at the wafer plane, require exceedingly fast resists with smaller exposure dose requirements.

One approach to a photo resist sensitive to deep ultraviolet radiation employs a compound that produces an acid moiety upon such irradiation (e.g., a photoacid generator or PAG) together with a polymer that reacts with the generated acid. Typical acid generator/acid sensitive polymer combinations include an onium salt as the photosensitive acid generator and a polymer such as poly(p-t-butoxycarbonyloxystyrene) as the polymer having a reactive substituent.

One illustration of such PAG/polymer combinations is shown in U.S. Patent No. 5,135,838, which issued to Houlihan et al. on August 4, 1992. This U.S. patent describes a deep ultra-violet radiation-sensitive composition containing a particular nitrobenzyl-based PAG and a polymer material that undergoes a reaction in response to an acid moiety.

The present invention is also directed to Deep UV photoacid generators based on a nitrobenzyl structure. The photoacid generator of the present invention may be used on both of the above-described exposure tools.

Accordingly, a first aspect of the present invention is directed to a nitro-benzyl photoacid generator composition as defined in claim 1.

A further aspect of the invention provides a radiation sensitive composition as defined in claim 3.

Still another aspect of the present invention is directed to a process for fabricating a device substrate comprising the steps of (1) forming a radiation sensitive region on a device substrate; (2) exposing at least a portion of said region to radiation to produce a latent pattern; (3) developing said pattern; and (4) using said developed patterned region as a mask to further process said device substrate; wherein said radiation sensitive region comprises a material including (a) a polymeric material that undergoes a reaction in response to an acid moiety and (b) an acid generating material represented by the above formula (I).

The radiation sensitive compositions of the present invention have two critical components, namely, (a) polymeric material that undergoes a reaction in response to an acid moiety and (b) an acid generating material according to the first aspect of the invention.

Any suitable polymeric material that undergoes a reaction in response to an acid moiety may be used in the radiation-sensitive composition aspect of the present invention.

One preferred polymeric material is described in U.S. Patent No. 4,996,136, which issued to Houlihan et al. on February 26, 1991.

The preferred photoacid generator is the reaction product of 2-nitro-6-trifluoromethyl-benzyl alcohol and 3,5-bis(trifluoromethyl)benzene-sulfonyl chloride and is represented by formula (II):

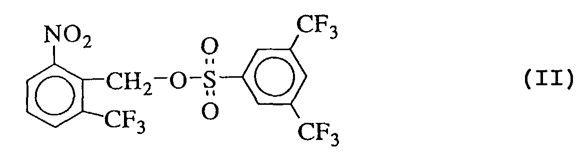

The preferred concentration between of the photoacid generator of the present invention is about 0.5 to about 50 weight percent of the acid-sensitive polymer. More preferably, PAG concentrations of about 1 to 20 weight percent are desirable.

The resist compositions of the present invention may contain other conventional materials, including solvents, dissolution inhibitors, dyes, and the like. The above-noted PAG and polymer may be dissolved in any suitable solvent. Ethyl 3-ethoxypropionate (EEP) is one preferred solvent.

The use of the resist material, including a suitable polymer and a photosensitive acid generator, involves the coating of the wafer to be processed. These resist materials are typically coated onto a substrate, e.g., a semiconductor based wafer such as a silicon wafer that is being processed to form semiconductor devices and exposed to deep ultraviolet radiation (or electrons or X-rays) to delineate a pattern for a subsequent process such as an etching or metallization process. It should be emphasized that during the processing of semiconductor wafers it is possible to form the photosensitive body by depositing the resist on a substrate surface that includes a semiconductor material, an insulator, such as a silicon oxide, a metal, or a combination of these materials. Exemplary of other suitable substrates are chromium mask blanks and X-ray mask blanks. Any conventional coating process may be used. Typically, the polymer is dissolved in a suitable solvent such as ethyl 3-ethoxypropionate (EEP), the solution is filtered and then placed on the wafer to be coated and the wafer is spun. The spinning procedure distributes the solution essentially uniformly on the surface of the wafer and also causes the evaporation of substantially all of the solvent. In this manner, films in the thickness range 0.2 µm to 2.0 µm (representative of thicknesses employed in lithography) are produced on an appropriate substrate material such as a silicon or GaAs wafer being processed into semiconductor devices.

After coating, the material is preferably prebaked to remove any remaining solvent. Preexposure baking temperatures in the range 70 to 105°C for times in the range 15 seconds to 60 minutes are desirable. The resist material is then exposed to energy such as deep UV light, X-rays, or electrons. Typical doses in the range 50 to 250 mJoules/cm² for deep UV light are employed. Corresponding doses for electron and X-ray irradiation may be useful. Conventional exposure techniques such as described in "Introduction to Microlithography", eds. L.F. Thompson, C.G. Wilson and M.J. Bowden, ACS Symposium, Series 219, pages 16-82 (1983), Washington, D.C. are employed to delineate the photosensitive material. It is then desirable to post-bake the exposed material. This post-bake enhances the cleavage reaction of chain substituents with the generated acid. Generally, post-bake temperatures in the range 70 to 115°C for time periods from 20 seconds to 30 minutes are effective. Although heating means such as a convection oven are useful, better image quality is obtained using a hot plate baking apparatus such as sold by Brewer Sciences. Solvents suitable for developing the exposed image are materials such as water/tetramethylammonium hydroxide, water/NaOH or lower alkyl alcohol mixtures of lower alkyl alcohols such as isopropanol ethanol and methanol with or without water for a positive image and hexane/methylene chloride for a negative image. Generally, immersion in the developer for time periods from 20 seconds to 2 minutes produces the desired delineation.

The present invention is further described in detail by means of the following Examples. All parts and percentages are by weight and all temperatures are degrees Celsius unless explicitly stated otherwise.

### EXAMPLE 1

### SYNTHESIS OF PHOTOACID GENERATOR

2.23 grams of 2-nitro-6-trifluoromethyl benzyl alcohol and 3.0 grams of 3,5-bis(trifluoromethyl)benzenesulphonyl chloride were combined in a 3-necked round bottom flask fitted with a nitrogen inlet, temperature probe and addition funnel. The system was purged with nitrogen and placed in an ice bath. 20 ml of acetone were then added to dissolve the solid mixture. A solution of dicyclohexylamine (1.85 grams) in five ml acetone was then added dropwise, keeping the reaction temperature below 10°C. On completion of the amine addition, the reaction mixture was stirred at approximately 5°C for 2 hours. The reaction mixture was stirred at approximately 5°C for 2 hours. The reaction mixture was then filtered to remove the amine hydrochloride salt which had precipitated; the filtrate was then evaporated to dryness to provide and oil, then was dissolved in methylene chloride. The methylene chloride solution was passed through a pad of silica gel. The silica gel was then washed with 50 mLs of methylene chloride. The filtrate was evaporated to give an oil which was then triturated with pentane to produce a white solid. This solid was then evaporated to dryness. Yield: 3.5 grams.

### EXAMPLE 2

### RESIST FORMULATION

1.190 grams of photoacid generator, 7.5 grams of poly[{4-(t-butoxycarbonyloxy)styrene} {4-(acetoxy)styrene}sulfur dioxide}terpolymer [wherein the molar ratio of the 4-(t-butoxy carbonyloxy)styrene to 4-(acetoxy)styrene moieties is 60:40 and the molar ratio of total phenol to SO₂ is 3:1] and 50 ml of ethyl 3-ethoxypropionate were placed in an amber bottle and rolled until dissolution occurred. The resist solution was filtered through a 0.2 µm membrane filter.

### EXAMPLE 3

### RESIST PROCESSING

Resist coatings were obtained by spin coating on silicon wafers followed by softbaking at 105°C for 60 seconds. A barrier coat layer was then coated onto the resist layer followed by a second bake at 105°C for 60 seconds. The coated wafers were then exposed on a GCA 0.35NA Laserstep. The exposed wafers were then baked at 115°C for 60 seconds and immersion developed in 0.262N tetramethylammonium hydroxide (TMAH) for 60 seconds. The threshold dose for the resist was 6 Dose Units whereas the optimal dose for 0.40 yam line/space pairs was approximately 13 dose units. The resist provided 0.35 µm resolution.

While the invention has been described above with reference to specific embodiments thereof, it is apparent that many changes, modifications and variations can be made without departing from the inventive concept disclosed herein.

## Claims

1. A nitrobenzyl-type photoacid generator composition comprising a compound of formula (I): 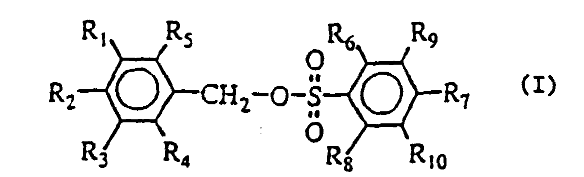
wherein R₁, R₂, and R₃ are individually selected from the group consisting of hydrogen and lower alkyl group having 1-4 carbon atoms;
wherein R₄ and R₅ are individually selected from the group consisting of CF₃ and NO₂ with the proviso that R₄ ad R₅ cannot both be CF₃;
wherein R₆, R₇, and R₈ are individually selected from the group consisting of hydrogen and lower alkyl group having 1-4 carbon atoms; and characterised in that R₉ and R₁₀ are CF₃.

2. The composition of claim 1 characterized in that said photoactive generator is represented by formula (II):

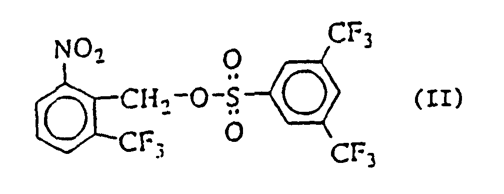

3. A radiation-sensitive composition comprising (a) a polymeric material that undergoes a reaction in response to an acid moiety and (b) a photoacid-generating composition that results in the generation of an acidic moiety as the result of irradiation with radiation and represented by a compound of formula (I): 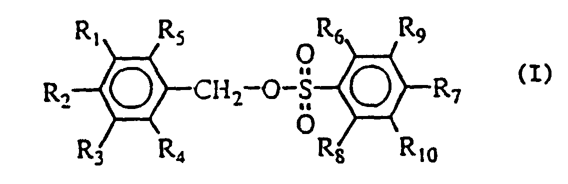
wherein R₁, R₂, and R₃ are individually selected from the group consisting of hydrogen and lower alkyl group having 1-4 carbon atoms;
wherein R₄ and R₅ are individually selected from the group consisting of CF₃ and NO₂ with the proviso that R₄ and R₅ cannot both be CF₃;
wherein R₆, R₇, and R₈ are individually selected from the group consisting of hydrogen and lower alkyl group having 1-4 carbon atoms; and characterised in that R₉ and R₁₀ are CF₃.

4. The radiation-sensitive composition of claim 3 characterized in that said photoacid generating composition comprises a compound of formula (II):

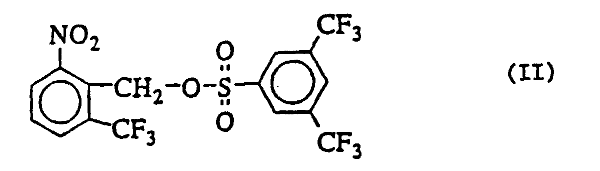

5. A process for fabricating a device characterized by the steps of:
(1) forming a radiation-sensitive region on a device substrate;
(2) exposing at least a portion of said region to radiation to produce a latent pattern;
(3) developing said pattern; and
(4) using said developed patterned region as a mask to further process said device substrate into a device; wherein said radiation sensitive material comprises:
(a) a polymeric material that undergoes a reaction in response to an acid moiety; and
(b) a photoacid generating composition that results in an acidic moiety as the result of irradiation with said radiation and comprises a compound of formula (I): 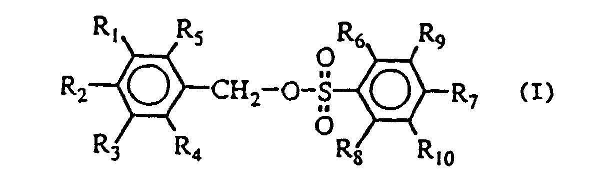
wherein R₁, R₂, and R₃ are individually selected from the group consisting of hydrogen and lower alkyl group having 1-4 carbon atoms;
wherein R₄ and R₅ are individually selected from the group consisting of CF₃ and NO₂ with the proviso that R₄ and R₅ cannot both be CF₃;
wherein R₆, R₇, and R₈ are individually selected from the group consisting of hydrogen and lower alkyl group having 1-4 carbon atoms; and characterised in that R₉ and R₁₀ are CF₃.

6. The process of claim 5 characterized in that said photoacid generating composition comprises a compound of formula (II):

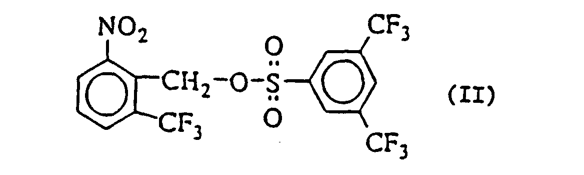

## Patentansprüche

1. Eine nitrobenzylartige Zusammensetzung zur Bildung einer lichtempfindlichen Säure, die eine Verbindung der nachstehenden Formel (1) enthält: 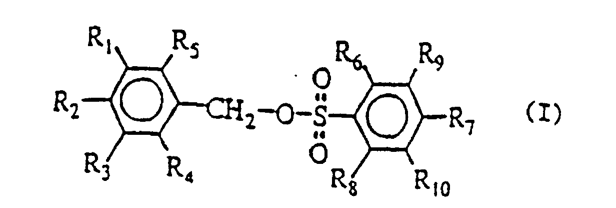
wobei R₁, R₂, und R₃ jeweils aus einer Gruppe bestehend aus Wasserstoff und einer niedermolekularen Alkylgruppe mit 1-4 Kohlenstoffatomen ausgewählt werden;
wobei R₄ und R₅ jeweils aus der Gruppe bestehend aus CF₃ und NO₂ unter der Voraussetzung ausgewählt werden, dass R₄ und R₅ nicht gleichzeitig CF₃ sein können;
wobei R₆, R₇, und R₈ jeweils aus einer Gruppe bestehend aus Wasserstoff und einer niedermolekularen Alkylgruppe mit 1-4 Kohlenstoffatomen ausgewählt werden; und dadurch gekennzeichnet, dass R₉ und R₁₀ CF₃ sind.

2. Die Zusammensetzung nach Anspruch 1 ist dadurch gekennzeichnet, dass die Verbindung zur Bildung einer lichtempfindlichen Säure durch Formel (II) dargestellt ist:

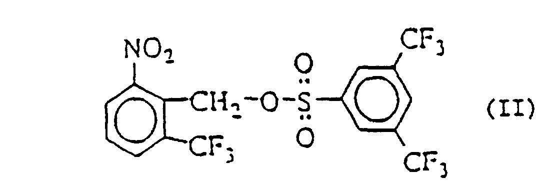

3. Eine strahlungsempfindliche Zusammensetzung, die (a) ein Polymermaterial enthält, das auf einen Säureanteil reagiert und (b) eine lichtempfindliche, säuregenerierende Zusammensetzung, die die Bildung eines Säureanteils als Ergebnis der Bestrahlung mit Strahlen zu Folge hat und durch eine Verbindung der nachstehenden Formel (1) dargestellt ist: 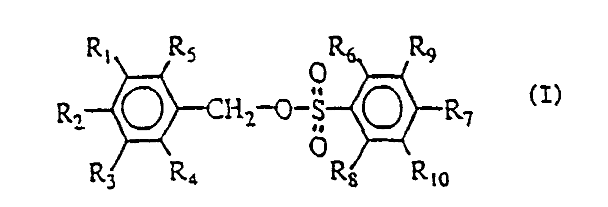
wobei R₁, R₂, und R₃ jeweils aus einer Gruppe bestehend aus Wasserstoff und einer niedermolekularen Alkylgruppe mit 1-4 Kohlenstoffatomen ausgewählt werden;
wobei R₄ und R₅ jeweils aus der Gruppe bestehend aus CF₃ und NO₂ unter der Voraussetzung ausgewählt werden, dass R₄ und R₅ nicht gleichzeitig CF₃ sein können;
wobei R₆, R₇, und R₈ jeweils aus einer Gruppe bestehend aus Wasserstoff und einer niedermolekularen Alkylgruppe mit 1-4 Kohlenstoffatomen ausgewählt werden; und dadurch gekennzeichnet, dass R₉ und R₁₀ CF₃ sind.

4. Die strahlungsempfindliche Zusammensetzung nach Anspruch 3, dadurch gekennzeichnet, dass die Zusammensetzung zur Bildung einer lichtempfindlichen Säure eine Verbindung der nachstehenden Formel (II) enthält:

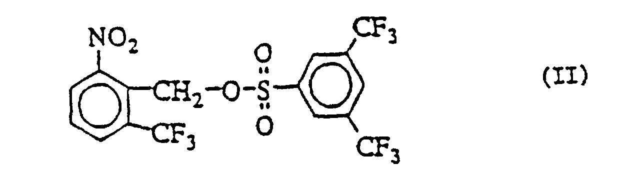

5. Ein Verfahren zur Herstellung einer Vorrichtung, gekennzeichnet durch die folgenden Schritte:
(1) Bildung eines strahlungsempfindlichen Bereichs auf einem Substrat der Vorrichtung;
(2) Bestrahlung von zumindest eines Teils dieses Bereichs, um ein Latentmuster herzustellen; und
(3) Entwicklung dieses Musters; und
(4) Verwendung dieses mit dem Muster ausgebildeten Bereichs als Maske, um aus diesem Substrat der Vorrichtung eine Vorrichtung zu machen; wobei das strahlungsempfindliche Material folgendes enthält:
(a) ein Polymermaterial, das auf einen Säureanteil reagiert; und
(b) eine Zusammensetzung zur Bildung einer lichtempfindlichen Säure, die einen Säureanteil als Ergebnis der Bestrahlung mit besagten Strahlen zur Folge hat und eine Verbindung der nachstehenden Formel (1) enthält: 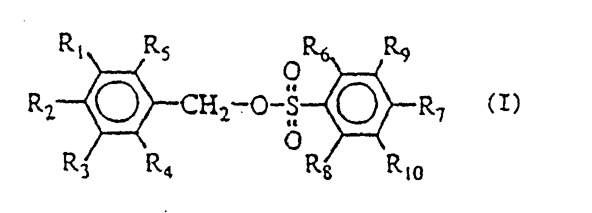
wobei R₁, R₂, und R₃ jeweils aus einer Gruppe bestehend aus Wasserstoff und einer niedermolekularen Alkylgruppe mit 1-4 Kohlenstoffatomen ausgewählt werden;
wobei R₄ und R₅ jeweils aus der Gruppe bestehend aus CF₃ und NO₂ unter der Voraussetzung ausgewählt werden, dass R₄ und R₅ nicht gleichzeitig CF₃ sein können;
wobei R₆, R₇, und R₈ jeweils aus einer Gruppe bestehend aus Wasserstoff und einer niedermolekularen Alkylgruppe mit 1-4 Kohlenstoffatomen ausgewählt werden; und dadurch gekennzeichnet, dass R₉ und R₁₀ CF₃ sind.

6. Das Verfahren nach Anspruch 5, dadurch gekennzeichnet, dass die Zusammensetzung zur Bildung einer lichtempfindlichen Säure eine Verbindung der nachstehenden Formel (II) enthält:

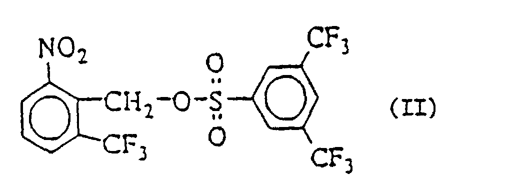

## Revendications

1. Une composition de génération photoacide de type nitrobenzylique comprenant un composé-conforme à la formule (I): 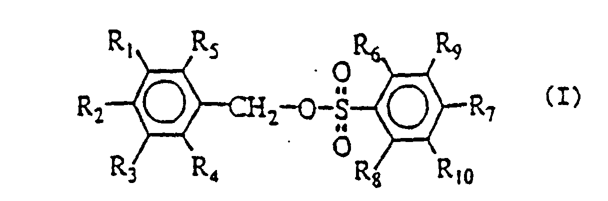
où R₁, R₂ et R₃ sont sélectionnés individuellement au sein du groupe consistant en hydrogène et en un groupe alkyle inférieur ayant 1-4 atomes de carbone ;
où R₄ et R₅ sont sélectionnés individuellement au sein du groupe consistant en CF₃ et NO₂, à condition toutefois que R₄ et R₅ ne puissent pas être tous les deux CF₃;
où R₆, R₇ et R₈ sont sélectionnés individuellement au sein du groupe consistant en hydrogène et en un groupe alkyle inférieur ayant 1-4 atomes de carbone ; et caractérisés par le fait que R₉ et R₁₀ sont CF₃.

2. Une composition conforme à la revendication 1 caractérisée par le fait que ladite composition de génération photoacide est représentée par la formule (II) :

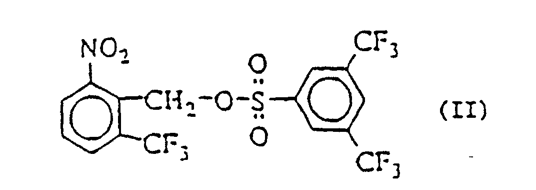

3. Une composition sensible aux rayonnements comprenant (a) un matériau polymérisé qui est soumis à une réaction en réponse à un fragment acide et (b) une composition de génération photoacide qui cause la génération d'un fragment acide à la suite d'irradiation avec des rayonnements et représentée par un composé conforme à la formule (I): 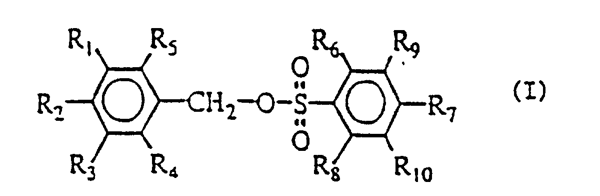
où R₁, R₂ et R₃ sont sélectionnés individuellement au sein du groupe consistant en hydrogène et en un groupe alkyle inférieur ayant 1-4 atomes de carbone ;
où R₄ et R₅ sont sélectionnés individuellement au sein du groupe consistant en CF₃ et NO₂, à condition toutefois que R₄ et R₅ ne puissent pas être tous les deux CF₃;
où R₅, R₇ et R₈ sont sélectionnés individuellement au sein du groupe consistant en hydrogène et en un groupe alkyle inférieur ayant 1-4 atomes de carbone ; et caractérisés par le fait que R₉ et R₁₀ sont CF₃.

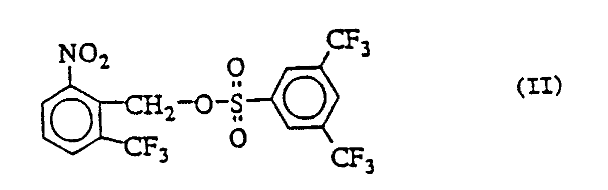

4. La composition sensible aux rayonnements conforme à la revendication 3 caractérisée par le fait que ladite composition de génération photoacide comprend un composé conforme à la formule (II):

5. Un procédé de fabrication d'un dispositif caractérisé par les étapes qui suivent :
(1) formation d'une région sensible aux rayonnements sur un substrat pour ce dispositif ;
(2) exposition d'au moins une partie de ladite région à des rayonnements afin de produire un motif latent ;
(3) développement desdits motifs ; et
(4) utilisation de ladite région à motifs développés pour servir de masque afin de traiter ensuite ledit substrat de dispositif à former un dispositif ; où ledit matériau sensible aux rayonnements comprend :
(a) un matériau polymérisé qui est soumis à une réaction en réponse à l'application d'un fragment acide ; et
(b) une composition de génération photoacide qui cause la génération d'un fragment acide à la suite d'irradiation avec des rayonnements et représentée par un composé conforme à la formule (I): 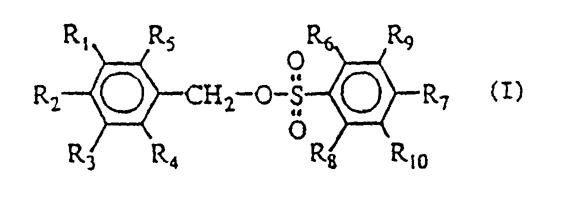
où R₁, R₂ et R₃ sont sélectionnés individuellement au sein du groupe consistant en hydrogène et en un groupe alkyle inférieur ayant 1-4 atomes de carbone ;
où R₄ et R₅ sont sélectionnés individuellement au sein du groupe consistant en CF₃ et NO₂, à condition toutefois que R₄ et R₅ ne puissent pas être tous les deux CF₃;
où R₆, R₇ et R₈ sont sélectionnés individuellement au sein du groupe consistant en hydrogène et en un groupe alkyle inférieur ayant 1-4 atomes de carbone ; et caractérisés par le fait que R₉ et R₁₀ sont CF₃.

6. Le procédé conforme à la revendication 5 caractérisé par le fait que ladite composition de génération photoacide comprend un composé conforme à la formule (II):
